# EUROPEAN PATENT APPLICATION

(11) **EP 4 661 151 A1**
(43) Date of publication of application: **10.12.2025**
(21) Application number: 24767377.5
(22) Date of filing: 05.03.2024
(51) Int. Cl.: H01M 10/42, B65G 47/90, G01R 31/385

(54) **BATTERY CELL HOLDING DEVICE AND BATTERY CELL PERFORMANCE TEST SYSTEM INCLUDING SAME**

(30) Priority: 06.03.2023 KR 20230029266
(71) Applicant: Apro Co., Ltd, Gunpo-si, Gyeonggi-do 15809 (KR)
(72) Inventor: LIM, Jong Hyun, Gunpo-si Gyeonggi-do 15809 (KR)
(74) Representative: Sander, Rolf
(86) International application number: PCT/KR2024/002769
(87) International publication number: WO 2024/186089

(57) **Abstract**

Disclosed are a battery cell holding device and a battery cell performance test system including the same. The battery cell holding device is configured to receive a tray loaded with battery cells, unload the battery cells from the tray and hold the battery cells, load tested battery cells into the tray, and transfer out the tested battery cells. The battery cell holding device includes a tray seating unit configured to receive a tray, a loading conveyor configured to load a predefined number of battery cells transferred thereto, a shuttle unit configured to transfer the battery cells introduced thereinto from one position to another position, a first transfer module configured to transfer the battery cells in the tray seated in the tray seating unit to the shuttle unit, and a second transfer module configured to transfer, to the loading conveyor, the battery cells transferred by the shuttle unit.

## Description

### CROSS-REFERENCE TO RELATED APPLICATIONS

This application is a continuation of International Application No. PCT/KR2024/002769 filed on March 5, 2024, which claims priority to Korean Patent Application No. 10-2023-0029266 filed on March 6, 2023, the entire contents of which are herein incorporated by reference.

### Technical Field

Embodiments of the present disclosure relate to a battery cell holding device and a battery cell performance test system including the same.

### Background Art

Contents described in this part merely provide background information of the present embodiment and do not constitute a conventional technology.

Recently, demand for portable electronic devices such as notebook computers, video cameras, and mobile phones has rapidly increased, and the development of electric vehicles, energy storage batteries, robots, and satellites has progressed in earnest. As a result, research into high-performance secondary batteries capable of repeated charging and discharging has actively proceeded.

Examples of commercially available secondary batteries include nickel-cadmium batteries, nickel-hydrogen batteries, nickel-zinc batteries, and lithium secondary batteries. Among the aforementioned examples, lithium secondary batteries are attracting attention because lithium secondary batteries hardly exhibit any memory effect compared to nickel-based secondary batteries, can be freely charged and discharged, have a very low rate of self-discharge, and offer high energy density. In general, such secondary batteries may be classified into can-type secondary batteries having a cylindrical or prismatic shape, and pouch-type secondary batteries, depending on the type of exterior material or application form.

A secondary battery may be used in the form of a single cell or in the form of a module in which a plurality of cells are electrically connected, depending on the type of external device in which the secondary battery is used. For example, a small device such as a mobile phone can operate for a predetermined period of time with the output and capacity of a single cell, whereas medium- or large-sized devices such as a notebook computer, a portable digital versatile disc (DVD) player, a small personal computer (PC), an electric vehicle, and a hybrid electric vehicle require the use of a module including a plurality of cells due to output and capacity limitations.

Pouch-type cells form an exterior by using a metal layer (foil) and a pouch exterior material coated on upper and lower surfaces of the metal layer, thereby significantly reducing the weight of a secondary battery compared to cylindrical or prismatic cells that use a metal can. The pouch-type cells enable weight reduction of a secondary battery and allow modification into various shapes. Therefore, the pouch-type cells have attracted significant attention, and usage thereof has gradually increased.

Each manufactured battery cell undergoes testing to determine whether the battery cell has the designed performance, and the battery cells having the target performance are shipped as final products.

A conventional battery cell performance test has been conducted as follows. Each battery cell is subjected to aging by being placed at room temperature for a predetermined period of time. Thereafter, the aged battery cells are tested for short-circuit occurrence while being in a pressurized state. In addition, charging and discharging are performed under high-temperature and pressurized conditions to determine whether charging and discharging are properly performed even under such environments.

According to a conventional battery cell performance test device, when aging of battery cells is completed, the (aged) battery cells are transferred using a tray to test equipment for testing short-circuit occurrence under a pressurized state. The battery cells are seated in the test equipment, in which the corresponding test is carried out, and after completion of the test, the battery cells are reseated on the tray. Thereafter, in order to perform charging/discharging tests (under high-temperature and pressurized conditions), the tray is transferred to a charging/discharging test device, and the battery cells are seated in the charging/discharging test device, in which the corresponding test is carried out. As such, since transfer processes between the respective test devices and seating processes between the test devices and the trays are extensively carried out, there has been an inconvenience in that the total time required to test the battery cells has unnecessarily increased.

### DISCLOSURE

### Technical Problem

An embodiment of the present disclosure is directed to providing a battery cell holding device and a battery cell performance test system including the battery cell holding device, which are configured to shorten the time required to test battery cell performance by simplifying a process of placing battery cells in an incoming tray and transfer paths to respective test devices.

### Technical Solution

According to an aspect of the present disclosure, a battery cell holding device may be configured to receive a tray loaded with battery cells to be tested, unload the battery cells from the tray and hold the battery cells, load tested battery cells into the tray, and transfer out the tray loaded with the tested battery cells. The battery cell holding device may include a tray seating unit configured to receive an incoming tray and an empty tray from which the battery cells are transferred, a loading conveyor configured to load a predefined number of battery cells transferred thereto, a shuttle unit configured to transfer the battery cells introduced thereinto and secured in place from one position to another position, a first transfer module configured to reciprocate between the tray seating unit and the shuttle unit and transfer the battery cells in the tray seated in the tray seating unit to the shuttle unit, and a second transfer module configured to reciprocate between the shuttle unit and the loading conveyor and transfer, to the loading conveyor, the battery cells transferred by the shuttle unit.

According to an aspect of the present disclosure, the shuttle unit may hold the battery cells transferred from the first transfer module and transfer the battery cells to the second transfer module.

According to an aspect of the present disclosure, the shuttle unit may include a guide formed along an axis, a body configured to move along the guide, a motor configured to provide driving force to allow the body to move along the guide, and a battery cell holder protruding from the body in a vertical upward direction and holding the battery cells.

According to an aspect of the present disclosure, the battery cell holder may include two battery cell holders facing each other as a set, the two battery cell holders being fixed to be spaced apart by a distance greater than a width of each of the battery cells by a predefined tolerance range.

According to an aspect of the present disclosure, each of the battery cells may be introduced and held between the set of battery cell holders.

According to an aspect of the present disclosure, two sets of battery cell holders, each set including the two battery cell holders, may be arranged on an axis identical to an axis of the guide and configured to hold a single battery cell.

According to an aspect of the present disclosure, the battery cell holders may receive and hold one or more battery cells.

According to an aspect of the present disclosure, the battery cell holding device may further include an unloading conveyor configured to receive a battery cell transferred thereto, the battery cell having been determined to be defective or having passed testing, a second shuttle unit configured to transfer the battery cell introduced thereinto and secured in place from one position to another position, a third transfer module configured to reciprocate between the second shuttle unit and the tray seating unit and transfer the battery cells transferred from the second shuttle unit to a tray seated in the tray seating unit, and a fourth transfer module configured to reciprocate between the unloading conveyor and the second shuttle unit and transfer the battery cell seated on the unloading conveyor to the second shuttle unit.

According to an aspect of the present disclosure, the battery cell holding device may further include a dummy conveyor configured to store a dummy battery cell seated thereon.

According to an aspect of the present disclosure, a battery cell performance test system may include the battery cell holding device, a test device configured to test electrical characteristics of a plurality of battery cells seated therein, a battery cell transfer device configured to reciprocate between the battery cell holding device and the test device, grip the plurality of battery cells, and transfer the plurality of battery cells from any one device to another device, and a controller configured to control respective operations of components in the battery cell performance test system.

### Advantageous Effects of Invention

As described above, according to an aspect of the present embodiment, there is an advantage in that the time required to test battery cell performance can be shortened by simplifying a process of placing battery cells in an incoming tray and transfer paths to respective test devices.

### Brief Description of Drawings

FIG. 1 is a plan view illustrating a configuration of a battery cell performance test system according to an embodiment of the present disclosure.
FIG. 2 is a view illustrating a configuration of a battery cell holding device according to an embodiment of the present disclosure.
FIG. 3 is a view illustrating a configuration of a first transfer module according to an embodiment of the present disclosure.
FIG. 4 is a view illustrating a configuration of a battery cell gripper in the first transfer module according to an embodiment of the present disclosure.
FIG. 5 is a view illustrating a second transfer module, a temporary loading unit, a loading conveyor, an unloading conveyor, and a dummy conveyor in a battery cell transfer module according to an embodiment of the present disclosure.
FIG. 6 is a view illustrating a configuration of a pressurized short-circuit test device according to an embodiment of the present disclosure.
FIG. 7 is a perspective view of a jig press plate according to an embodiment of the present disclosure.
FIG. 8 is a view illustrating a region of a jig plate to which pressure is applied by the jig press plate according to an embodiment of the present disclosure.
FIG. 9 is a perspective view of the jig plate according to an embodiment of the present disclosure.
FIG. 10 is a side view of the jig plate according to an embodiment of the present disclosure.
FIG. 11 is a view illustrating a configuration of a preheating and prepressurizing device according to an embodiment of the present disclosure.
FIG. 12 is a perspective view of the jig plate in the preheating and prepressurizing device according to an embodiment of the present disclosure.
FIG. 13 is a view illustrating a configuration of a high-temperature pressurized charging/discharging device according to an embodiment of the present disclosure.
FIG. 14 is a view illustrating a configuration of a charge/discharge gripper according to an embodiment of the present disclosure.
FIG. 15 is a view illustrating an implementation example of the charge/discharge gripper according to an embodiment of the present disclosure.
FIG. 16 is a view illustrating a structural relationship among the jig plate, the charge/discharge gripper, and a battery cell in the high-temperature pressurized charging/discharging device according to an embodiment of the present disclosure.
FIG. 17 is a view illustrating an implementation example of a battery cell.

### Mode for Invention

The present disclosure may be modified in various forms and may have various embodiments, and specific embodiments thereof are shown by way of example in the drawings and described in detail. However, it should be understood that the description is not intended to limit the present disclosure to the specific embodiments, but, on the contrary, the present disclosure is to cover all modifications, equivalents, and alternatives that fall within the spirit and scope of the present disclosure. Like reference numerals are used to designate like elements throughout the drawings.

Although the terms "first," "second,", "A", "B", etc. may be used herein in reference to various elements, such elements should not be construed as limited by these terms. These terms are only used to distinguish one element from another element. For example, a first element could be termed a second element, and a second element could be termed a first element, without departing from the scope of the present disclosure. The term "and/or" includes any and all combinations of one or more of the associated listed items.

It should be understood that when an element is referred to as being "connected" or "coupled" to another element, it can be directly connected or coupled to the other element or intervening elements may be present. In contrast, it should be understood that when an element is referred to as being "directly connected" or "directed coupled" to another element, there is no intervening element.

Terms used in the present specification are used only to describe specific embodiments, and are not intended to limit the present disclosure. A singular form may include a plural form if there is no clearly opposite meaning in the context. In this specification, it should be understood that the term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance.

Unless otherwise defined, all terms including technical and scientific terms used herein have the same meaning as commonly understood by those of ordinary skill in the art to which the present disclosure pertains.

It will be further understood that terms defined in commonly used dictionaries should be interpreted as having a meaning that is consistent with their meaning in the context of the related art and will not be interpreted in an idealized or overly formal sense unless expressly so defined herein.

The configurations, processes, steps, or methods according to embodiments of the present disclosure may be shared as long as they do not technically conflict with each other.

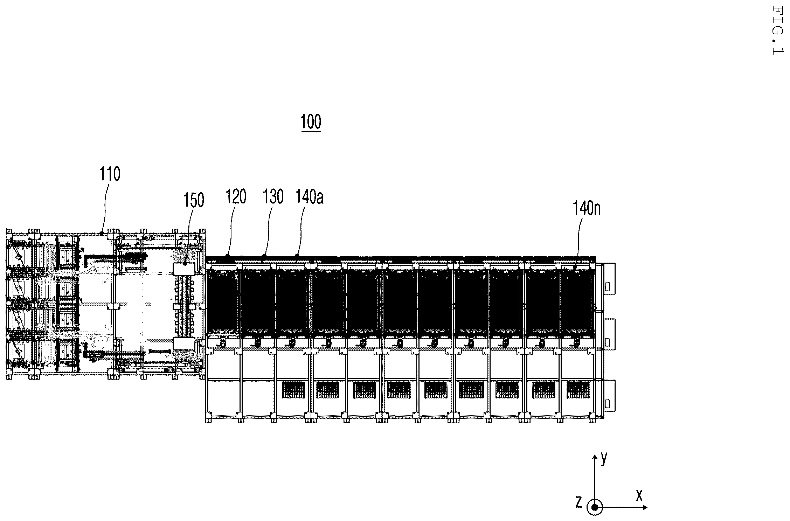

FIG. 1 is a plan view illustrating a configuration of a battery cell performance test system according to an embodiment of the present disclosure.

Referring to FIG. 1, a battery cell performance test system 100 (hereinafter referred to as "system") according to an embodiment of the present disclosure includes a battery cell holding device 110 (hereinafter referred to as "holding device"), a pressurized short-circuit test device 120 (hereinafter referred to as "first device"), a preheating and prepressurizing device 130 (hereinafter referred to as "second device"), a high-temperature pressurized charging/discharging device 140 (hereinafter referred to as "third device"), a battery cell transfer device 150 (hereinafter referred to as "transfer device"), and a controller (not shown).

The system 100 tests characteristics of battery cells that are inserted into a battery, such as a pouch-type battery, a cylindrical battery, or a thin-profile battery. In particular, the system 100 tests whether the battery cells have designed electrical characteristics under a condition in which a certain level of pressure or both a certain temperature and pressure are applied. Particularly, the system 100 tests whether a short circuit occurs in a battery cell under a condition in which a certain level of pressure is applied, and tests whether charging and discharging are properly performed under a condition in which both a certain temperature and pressure are applied.

The holding device 110 receives a tray loaded with battery cells (to be tested), temporarily holds the battery cells in the tray, and loads tested battery cells into the tray so that the tested battery cells can be transferred out.

A tray loaded with battery cells to be tested is introduced into the holding device 110. After the holding device 110 receives the tray, the holding device 110 removes the battery cells from the tray and holds the battery cells in a manner suitable for the transfer device 150 to transfer the battery cells. The holding device 110 repeatedly removes the battery cells from the tray and holds the battery cells in quantities corresponding to the number of battery cells (which is defined as one channel) that the transfer device 150 can transfer at once.

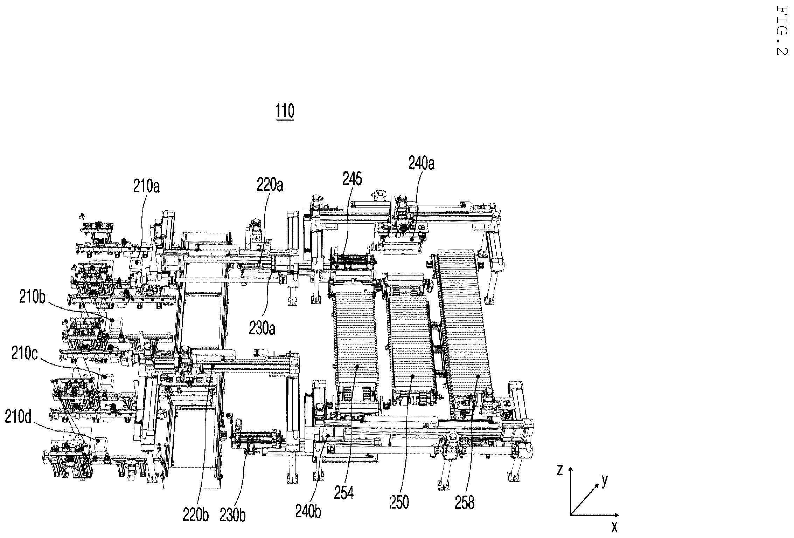

The holding device 110 loads, into a tray, tested battery cells that have passed through the first to third devices, or battery cells including a cell having a defect. When the battery cells described above are transferred by the transfer device 150, the holding device 110 temporarily holds the battery cells and then loads the held battery cells into an empty tray. The tested battery cells loaded into the tray are transferred out for a subsequent process. A detailed description of the holding device 110 will be provided below with reference to FIGS. 2 to 5.

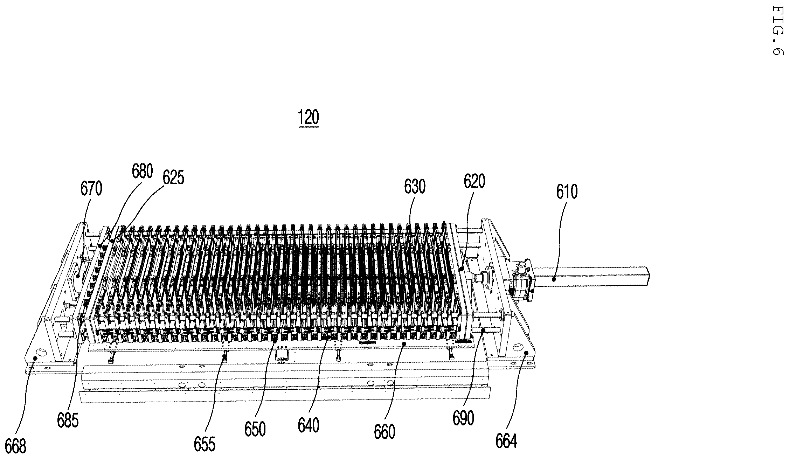

The first device 120 tests, under a predefined environment, whether a short circuit has occurred in a plurality of battery cells (within one channel) seated therein. The first device 120 receives each of the battery cells transferred from the holding device 110 by the transfer device 150. The first device 120 is electrically connected to the seated battery cells and applies a predefined pressure to the battery cells. The first device 120 may apply a relatively uniform pressure to each of the battery cells, compared to conventional arts. While pressure is applied to each of the battery cells (within one channel), the first device 120 supplies power to each of the battery cells. The first device 120 tests electrical characteristics of the battery cells that receive power under the foregoing condition, for example, whether a short circuit has occurred. The first device 120 primarily determines whether any abnormality is present in each of the battery cells (within one channel) through the foregoing test. A detailed description of the respective components of the battery cell transfer device 150 will be made below with reference to FIGS. 6 to 10.

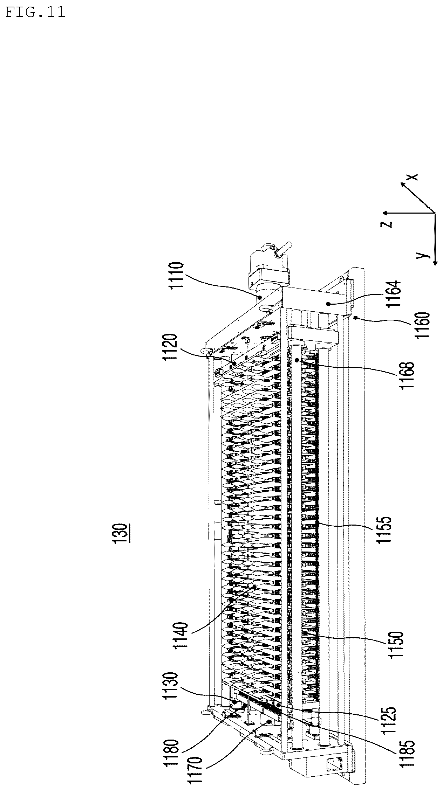

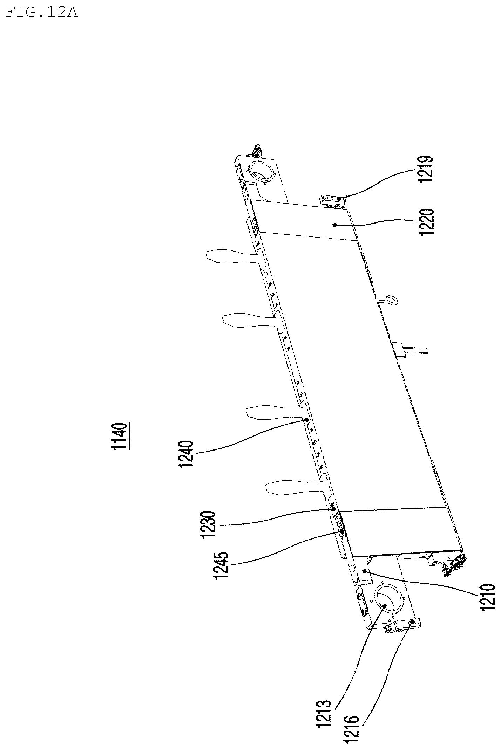

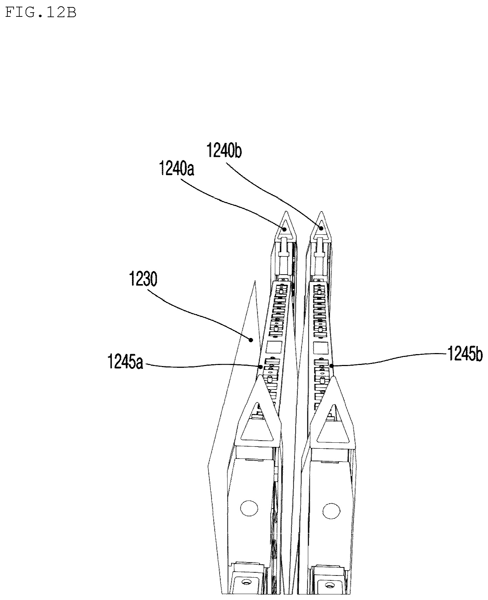

The second device 130 pre-pressurizes and preheats a plurality of battery cells (within one channel) seated therein. The second device 130 receives each of the battery cells transferred from the first device 120 by the transfer device 150. The second device 130 does not separately test electrical characteristics of the battery cells, but applies a certain pressure and heat to the battery cells (within one channel). The third devices 140a to 140n perform tests on the charge and discharge levels of the battery cells under conditions in which a specific temperature and pressure are applied. However, in order for the battery cells to be properly tested by the third devices 140a to 140n, the battery cells are required to be primarily exposed to a second environment (temperature and pressure) that is different from a first environment (specific temperature and pressure) under which the third devices perform testing. Thereafter, the battery cells are required to be exposed to the first environment under which the third devices perform testing, thereby allowing testing to be performed. The second device 130 exposes the battery cells to the second environment and performs preprocessing, thereby enabling the third devices 140a to 140n to perform testing on the battery cells under the first environment. A detailed structure of the second device 130 will be described below with reference to FIGS. 11 and 12.

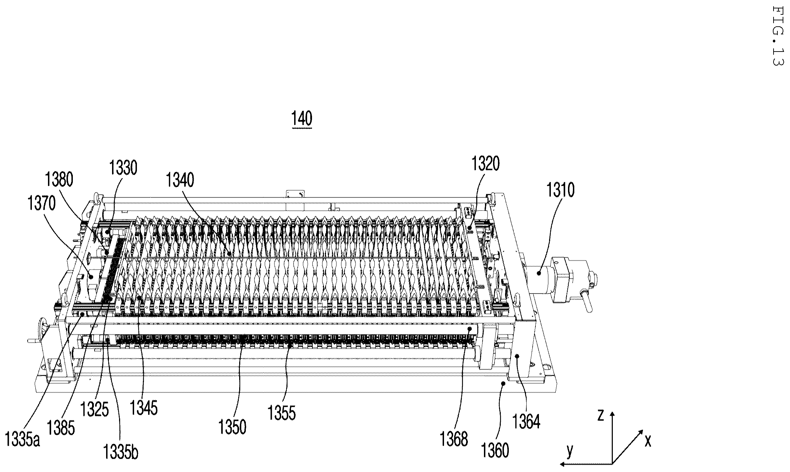

The third devices 140a to 140n test whether a plurality of battery cells (within one channel), which are seated therein, properly perform charging and discharging under a predefined environment. The third devices 140a to 140n receive, from the second device 130 by the transfer device 150, respective battery cells that have been preheated and pre-pressurized. The third devices 140a to 140n test whether the battery cells perform charging and discharging as designed under conditions in which a temperature and a pressure equal to or greater than predefined threshold values are applied thereto. Although the time required for the test performed by the third devices 140a to 140n is shortened by the second device 130, the test still takes a relatively long time. Therefore, the system 100 may include the plurality of the third devices 140a to 140n. By including the plurality of third devices 140a to 140n, the system 100 may meet a test speed corresponding to a speed at which the battery cells are introduced into the holding device 110 for testing. A detailed structure of the third devices 140a to 140n will be described below with reference to FIGS. 13 to 16.

The transfer device 150 reciprocates between the holding device 110 and the third devices 140a to 140n, grips battery cells (within one channel), and transfers the battery cells from one device to another device. The first device 120 is disposed adjacent to the holding device 110 and, in particular, is spaced apart by a predefined distance along the same axis (x-axis) from a space (loading conveyor, to be described below with reference to FIG. 2) in which a tray is received and battery cells in the tray are held. The second device 130 is disposed in a position parallel to the first device 120, and the third devices 140 are respectively disposed parallel to the second device 130 or to adjacent ones of the third devices. Accordingly, from the holding device 110 to the third device 140n, the components are arranged in parallel along the same axis (x-axis in FIG. 1), and the transfer device 150 reciprocates along the axis to transfer a predefined number of battery cells (within one channel) (at a time).

The transfer device 150 is movable along the corresponding axis and includes a gripping structure configured to grip a plurality of battery cells (within one channel). The transfer device 150 grips the plurality of battery cells and transfers the gripped battery cells from one device to another device. Regardless of the movement of the transfer device 150 along the corresponding axis, the gripping structure may move in a vertical direction (z-axis). Accordingly, in order for the transfer device 150 to transfer the battery cells from one device to another device, the transfer device 150 is positioned vertically above the one device, and the gripping structure in the transfer device 150 descends toward the one device. After the gripping structure grips the battery cells in the one device, the transfer device 150 raises the gripping structure vertically upward and then moves to the other device. The transfer device 150 stops above the other device and lowers the gripping structure toward the other device, thereby transferring the plurality of battery cells from the one device to the other device. As described above, since the components from the holding device 110 to the third device 140n are arranged in parallel along the same axis, the system 100 does not require a separate conveyor or the like for transfer from one device to another device. Because the battery cells can be directly transferred from one device to another without a separate conveyor, a transfer process between each device and a conveyor can also be omitted. Accordingly, the system 100 can not only reduce the test time but also reduce the number of components of the entire system and decrease the overall size (volume) of the system.

The controller (not shown) controls the operations of the devices 110 to 150 in the system 100 and all operations of each component, which will be described below with reference to FIGS. 2 to 17.

When a tray loaded with battery cells for testing is introduced into the holding device 110, the controller (not shown) controls the holding device 110 to transfer battery cells (within one channel) from the tray and temporarily hold the battery cells. Thereafter, the controller (not shown) controls the transfer device 150 to transfer the battery cells (within one channel) from the holding device 110 to the first device 120, from the first device 120 to the second device 130, and from the second device 130 to one of the third devices 140a to 140n.

When testing is completed by the third devices 140a to 140n, the controller (not shown) controls the transfer device 150 to transfer the battery cells from the third devices 140a to 140n, which have completed testing, to the holding device 110, and controls the holding device 110 such that, when tested battery cells are held in the holding device 110, the tested battery cells are transferred to an empty tray.

In the case where it is determined that a defective battery cell is present based on a test result of the first device 120 or the third devices 140a to 140n, the controller (not shown) identifies the corresponding defective battery cell and the plurality of battery cells transferred together (within the same channel), and directly loads the battery cells into an empty tray (via the holding device) without performing the remaining tests. For example, when a battery cell having an abnormality in short-circuiting is present within one channel according to test by the first device 120, there is no need to additionally perform the operation of the second device 130 or the test by the third devices 140a to 140n for the battery cells of the corresponding channel. Accordingly, the controller (not shown) loads the plurality of battery cells (which are test targets) determined to be defective into an empty tray via the holding device 110. The controller (not shown) loads the plurality of battery cells identified as defective into the tray and transfers out the battery cells (separately). Accordingly, the controller (not shown) is able to accurately distinguish and remove the battery cells determined to be defective, thereby maintaining test efficiency in terms of speed by preventing the battery cells determined to be defective from undergoing unnecessary test processes.

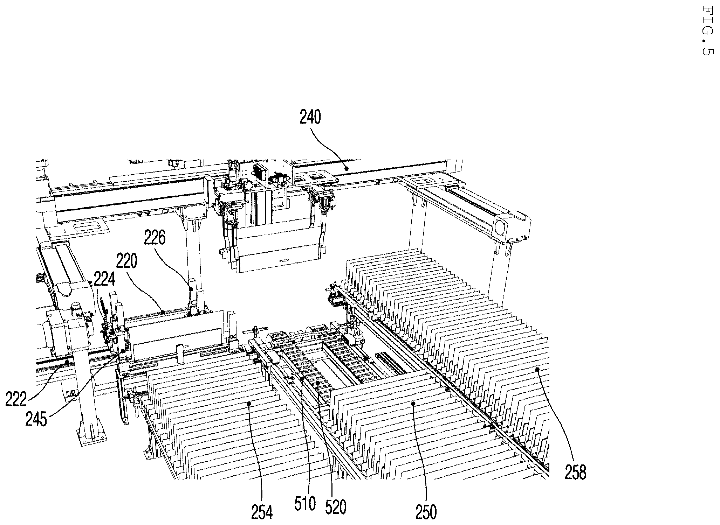

FIG. 2 is a view illustrating a configuration of the battery cell holding device according to an embodiment of the present disclosure. FIG. 5 is a view illustrating a second battery cell transfer module, a temporary loading unit, a loading conveyor, an unloading conveyor, and a dummy conveyor in a battery cell transfer module according to an embodiment of the present disclosure.

Referring to FIGS. 2 and 5, the holding device 110 according to an embodiment of the present disclosure includes tray seating units 210a to 210d, a first transfer module 220, a shuttle unit 230, a second transfer module 240, a temporary loading unit 245, a loading conveyor 250, an unloading conveyor 254, and a dummy conveyor 258.

The tray seating units 210 are configured to receive an incoming tray (loaded with battery cells for testing) and an empty tray from which battery cells have been transferred. The tray seating units 210 each have a width greater than that of the tray, thus allowing the tray to be smoothly introduced thereinto and seated therein. Although FIG. 2 illustrates that the holding device 110 includes four tray seating units 210a to 210d, the number of tray seating units is not limited thereto.

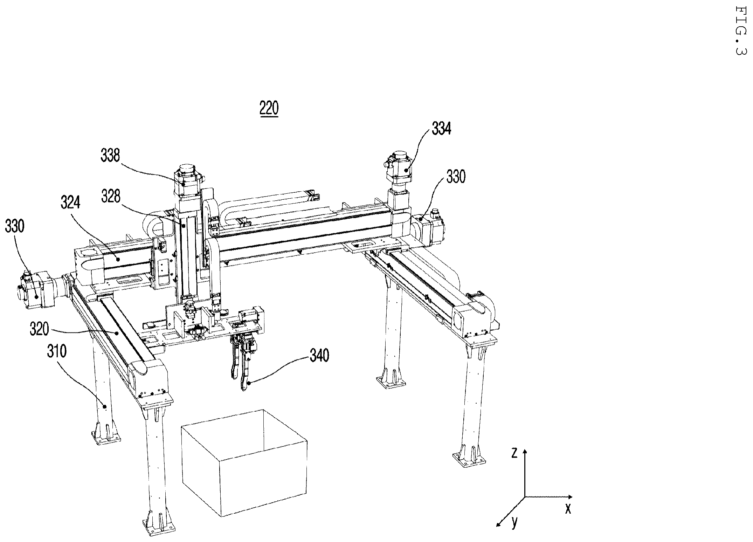

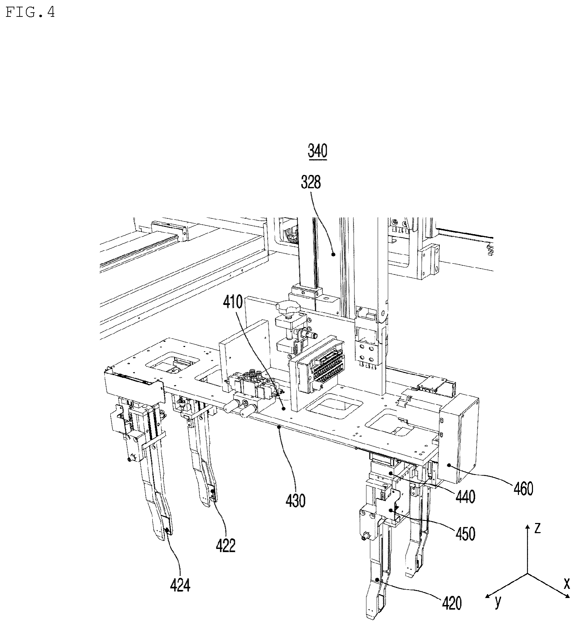

The first transfer module 220a reciprocates between each tray seating unit 210 and the shuttle unit 230a, and transfers battery cells in a tray seated in the tray seating unit 210 to the shuttle unit 230a. A detailed structure of the first transfer module 220a is illustrated in FIGS. 3 and 4.

FIG. 3 is a view illustrating a configuration of the first transfer module according to an embodiment of the present disclosure. FIG. 4 is a view illustrating a configuration of a battery cell gripper in the first transfer module according to an embodiment of the present disclosure.

Referring to FIGS. 3 and 4, the first transfer module 220a according to an embodiment of the present disclosure includes a support 310, a first guide 320, a second guide 324, a third guide 328, a first motor 330, a second motor 334, a third motor 338, and a battery cell gripper 340. The battery cell gripper 340 includes a gripper body 410, a gripper 420, a guide 430, a guide moving unit 440, a gripper cylinder 450, and a motor 460.

The support 310 enables the remaining components of the first transfer module 220a to be spaced apart from a lowermost end of the system 100 by a predetermined distance in a vertical upward direction. The support 310 is in contact at one end thereof with the bottom surface of the system 100 and at a remaining end thereof with the first guide 320, thereby enabling the first guide 320 and the remaining components of the first transfer module 220a connected thereto to be spaced apart from a lowermost surface of the system 100. Due to the support 310, a space is secured for the battery cell gripper 340 to move upward and downward in the vertical direction.

The first guide 320 is formed along an axis (y-axis) that is perpendicular to the axis along which the devices 110 to 150 are aligned. The first guide 320 is formed on the one end of the support 310 and allows the second guide 324 to move on the corresponding axis (y-axis) along the first guide 320. As the first guide 320 is formed along the corresponding axis (y-axis), the battery cell gripper 340 can eventually approach either the tray seated in the tray seating unit 210 or the shuttle unit 230a along the corresponding axis (y-axis).

Two first guides 320 are arranged to face each other, such that the second guide 324 can be disposed on top of the first guides 320.

The second guide 324 is formed on the first guides along the axis (x-axis) along which the devices 110 to 150 are aligned. The second guide 324 is formed along the corresponding axis on the first guides, and allows the third guide 328 to move along the second guide 324 on the corresponding axis (x-axis). As the second guide 324 is formed along the corresponding axis (x-axis), the battery cell gripper 340 can ultimately move along the corresponding axis (x-axis) to approach either the tray seated in the tray seating unit 210 or the shuttle unit 230a.

The third guide 328 is formed along a vertical axis. The third guide 328 is formed on the second guide 324 along the corresponding axis, and allows the battery cell gripper 340 to move along the third guide 328 on the corresponding axis (z-axis). As the third guide 328 is formed along the corresponding axis (z-axis), the battery cell gripper 340 can eventually move closer to or farther from either the tray seated in the tray seating unit 210 or the shuttle unit 230a along the corresponding axis (z-axis).

The first motor 330 supplies driving force to the second guide 324 to enable the second guide 324 to reciprocate on the first guides 320. The second guide 324 receives the driving force from the first motor 330 and may move along the first guides 320 on the y-axis to approach either the corresponding tray or the shuttle unit 230a.

The second motor 334 supplies driving force to the third guide 328 to enable the third guide 328 to reciprocate on the second guide 324. The third guide 328 receives the driving force from the second motor 334 and may move along the second guide 324 on the x-axis to approach either the corresponding tray or the shuttle unit 230a.

The third motor 338 supplies driving force to the battery cell gripper 340 to enable the battery cell gripper 340 to reciprocate on the third guide 328. The battery cell gripper 340 receives the driving force from the third motor 338 and may move along the third guide 328 on the z-axis to approach or move away from either the corresponding tray or the shuttle unit 230a.

The battery cell gripper 340 (using the driving force received from the third motor 338) moves on the third guide 328 to grip battery cells in the tray or to seat the gripped battery cells on the shuttle unit 230a.

The gripper body 410 is coupled to the third guide 328 to move on the third guide 328, and supports components provided in the battery cell gripper 340. The gripper body 410 may be formed by coupling a plurality of components in an L-shape or may be implemented as a single component bent in an L-shape. One end of the gripper body 410 is coupled to the third guide 328 so as to be movable along the third guide 328, and one surface of a remaining end of the gripper body 41 supports the components provided in the battery cell gripper 340 in a vertical downward direction. Accordingly, the gripper 420 may face in the vertical downward direction.

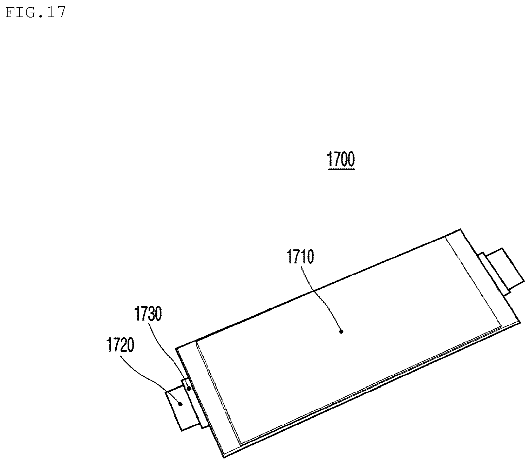

Two grippers 420 facing each other form one set to grip a lead on one side of a battery cell. The two facing grippers 420 form each set, and two sets are arranged along the axis, on which the devices 110 to 150 are aligned, so as to grip one battery cell. The structure of the battery cell is illustrated in FIG. 17.

FIG. 17 is a diagram illustrating an implementation example of a battery cell.

Referring to FIG. 17, a battery cell 1700 includes a battery body 1710 that generates power, leads 1720, and cell terraces 1730 protruding from opposite sides of the battery body 1710 to allow the battery body 1710 to be smoothly transferred. The cell terraces 1730 are structured to enable the battery body 1710 to be transferred intact during a test process without damage.

Referring again to FIGS. 3 and 4, the pair of facing grippers 420 move toward or away from each other by the gripper cylinder 450 to grip the battery cell 1700, particularly the lead 1720 on one side of the battery cell 1700.

The gripper 420 further includes a gripper pad 422 at one end thereof. The gripper pad 422 is provided at each of the ends (vertical downward ends) of the inner surfaces of the respective grippers 420 facing each other in each set of grippers 420, thereby enhancing gripping force when the grippers 420 grip the lead 1720 and preventing damage to the lead 1720 and the grippers 420. The gripper pad 422 has a width equal to or smaller than that of the gripper 420 to contact and grip the lead 1720 at a corresponding position without protruding outward. The gripper pad 422 is formed of a material, such as silicone, which has elasticity and a frictional force equal to or greater than a predefined reference value, thereby enhancing the gripping force.

In the conventional art, a gripper pad is fixed to the end of the gripper 420 by an adhesive such as double-sided tape. As such, in the case where the gripper pad is fixed to the gripper 420 by the adhesive, detachment of the gripper pad may frequently occur due to insufficient adhesive strength. Even when reattaching the gripper pad, the area where the adhesive had been applied must be cleaned by a separate removal method, such as alcohol, before the adhesive can be reapplied, which results in considerable inconvenience. Accordingly, the above-described material may be fixed to one surface of the gripper pad 422 by heat sealing, and a material equal or similar to that of the gripper 420 may be fixed to a remaining surface of the gripper pad 422. Thereafter, the gripper pad 422 is fixed to the gripper 420 by fastening the remaining surface to the gripper 420 using a fastener such as bolts and nuts. As a result, the lifespan and coupling strength of the gripper pad 422 are enhanced, and no additional post-treatment is required even when the gripper pad 422 is removed from the gripper 420.

Any one or both of the grippers 420 in a set include a (battery cell) detection sensor at an end (the vertical downward end) thereof. The simplest type of detection sensor may be implemented as a sensor including a light source 424 and a light-receiving unit (not shown). For example, in the case where the detection sensor is implemented in the aforementioned structure, the light source 424 is provided on one of the grippers 420 in a set, and the light-receiving unit (not shown) is provided on the other gripper 420, such that the light source 424 and the light-receiving unit (not shown) are formed at positions that face each other. When a set of grippers 420 does not grip a battery cell, light emitted from the light source 424 is received by the light-receiving unit (not shown). On the other hand, when the set of grippers 420 grips a battery cell, the light emitted from the light source 424 cannot be transmitted to the light-receiving unit. As the grippers 420 are provided with the detection sensor, it is possible to detect whether a battery cell is gripped. However, the aforementioned structure is merely an example assuming that the detection sensor is implemented with a light source and a light-receiving unit. In the case where the detection sensor is implemented in another configuration, the detection sensor may be provided in a different form on any one or both of the grippers 420 in a set.

FIGS. 3 and 4 illustrate a structure in which a total of four sets of grippers 420 are implemented, each set configured as a pair, thereby allowing two battery cells to be gripped at a time. However, the disclosure is not limited thereto. For example, two sets of grippers may be provided to grip only one battery cell at a time, or a greater number of gripper sets may be implemented to grip three or more battery cells at a time. Even though multiple sets of the gripper 420 are provided, the grippers 420 cannot be implemented in a number corresponding to the number of battery cells transferred at a time by the transfer device 150, due to the size of the first device 120 and structural constraints of each component provided in the first device 120. Accordingly, to transfer the battery cells in the tray, the first transfer module 220a performs the transfer of battery cells multiple times or continuously.

The guide 430 is disposed on the gripper body 410 in the axis direction in which the devices 110 and 150 are aligned. The guide moving unit 440 is provided on a remaining end of the gripper 420 to move along the guide 430 in an axial direction of the guide 430. Two sets of grippers 420 are implemented on the guide 430 and move along the guide 430. Accordingly, the sets of grippers 420 can move toward each other or away from each other. As a result, even when the distance between both leads 1720 of a battery cell to be tested varies rather than being constant, the respective sets of grippers 420 can reliably grip both leads 1720 of the battery cell.

The gripper cylinder 450 adjusts the distance between the grippers 420 in a set along the y-axis, which is perpendicular to the axis along which the devices 110 to 150 are aligned. The grippers 420 in a set that face each other may be moved toward or away from each other by the gripper cylinder 450. The grippers 420 in a set may move toward each other by the gripper cylinder 450 to grip the corresponding lead of a battery cell positioned therebetween, or move away from each other to release the gripped lead of the battery cell.

The first transfer module 220a has the aforementioned configuration and reciprocates between the tray seating unit 210a and the shuttle unit 230a to transfer battery cells from a tray seated in the tray seating unit 210a to the shuttle unit 230a.

Referring again to FIGS. 2 and 5, the shuttle unit 230a reciprocates between the first transfer module 220a and the second transfer module 240a so as to transfer, to the lower end of the second transfer module 240a, the battery cells transferred from the tray by the first transfer module 220a, thereby allowing the second transfer module 240a to transfer the battery cells.

The shuttle unit 230a includes a guide 222 formed along the axis (x-axis) on which the devices 110 to 150 are aligned, a body 224 that moves along the guide 222, a motor (not shown) that supplies driving force to move the body 224 along the guide 222, and a battery cell holder 226 that protrudes in a vertical upward direction from the body 224 to hold a battery cell.

The battery cell holder 226 has a structure similar to that of the gripper 420; however, unlike the gripper 420, it is not configured to allow adjustment of the distance between a pair of holders 226 that face each other as a set. Instead, the pair of holders 226 in a set are fixed to be spaced apart by a distance equal to or greater than the width of the battery cell, particularly, the lead 1720 of the battery cell, by a predefined tolerance range. The lead of the battery cell is inserted between the pair of holders 226 in a set and is held in place. Here, two battery cell holders 226 are arranged along the axis (x-axis) to hold one battery cell, and one set of battery cell holders 226 includes the same number of holders as the number of sets of grippers 420. Because one set of battery cell holders 226 includes the same number of holders as the number of sets of grippers 420, the battery cell holders 226 may receive the same number of battery cells as the number of battery cells transferred by the grippers 420.

In order to receive the battery cell initially transferred from the first transfer module 220, the battery cell holders 226 move to a position closest to the first transfer module 220 along the guide 222. Thereafter, in the case where the battery cell transferred from the first transfer module 220 is seated in the battery cell holders 226, the battery cell holders 226 receive driving force from the motor (not shown) and move along the guide 222 to a position closest to the second transfer module 240a.

The second transfer module 240a has the same structure as the first transfer module 220. The second transfer module 240a reciprocates between the shuttle unit 230a and the loading conveyor 250 to transfer battery cells, transferred by the shuttle unit 230a, to the loading conveyor 250. In some cases, the second transfer module 240a reciprocates between the temporary loading unit 245 and the dummy conveyor 258 to transfer battery cells to the loading conveyor 250. The second transfer module 240a transfers the battery cells, transferred by the shuttle unit 230a, to the loading conveyor 250, but not continuously; rather, the second transfer module 240a transfers only a number of battery cells equal to the total number that the transfer device 150 can transfer at a time. When the second transfer module 240a transfers a corresponding number of battery cells to the loading conveyor 250, the transfer device 150 grips the battery cells and transfers the battery cells to the first device 120. Thereafter, the second transfer module 240a transfers battery cells to the loading conveyor 250 again until the number of battery cells reaches the corresponding number.

The temporary loading unit 245 is located within a movable range of the second transfer module 240a (more specifically, of the battery cell grippers). Typically, battery cells (in each tray) introduced into the holding device 110 are supplied in a predetermined quantity, usually an even number. However, in the course of various processes, there may be cases where, unintentionally, the number of battery cells introduced into the tray does not match the predetermined quantity. In particular, there may be cases where an odd number of battery cells are introduced into the tray. In the case where battery cells in such an insufficient quantity are transferred by the transfer device 150 to each of the devices 120 to 140 and undergo test, problems such as damage to each of the devices 120 to 140 may occur. In view of the foregoing, the temporary loading unit 245 is positioned at the above-described location. In the case where only one battery cell is gripped and transferred, the second transfer module 240a transfers the battery cell to the temporary loading unit 245, rather than directly transferring the battery cell to the loading conveyor 250. The temporary loading unit 245 is formed in the same structure as the battery cell holder 226 of the shuttle unit 230, but is implemented to receive one battery cell (with two sets of battery cell holders arranged on the x-axis). Accordingly, in the above-described situation, the second transfer module 240a may place one battery cell on the temporary loading unit 245. In the case where one battery cell is gripped, the second transfer module 240a holds the battery cell on the temporary loading unit 245, and transfers the battery cells transferred from the shuttle unit 230a to the loading conveyor 250 in the same manner as during normal operation (i.e., in the case of a plurality or an even number of battery cells). In the case where one battery cell is seated on the temporary loading unit 245, and the second transfer module 240a additionally grips only one battery cell during a process of transferring the number of battery cells corresponding to the total number that the transfer device 150 can transfer at a time to the loading conveyor 250, the second transfer module 240a additionally grips the one battery cell seated on the temporary loading unit 245 and transfers the battery cells together to the loading conveyor 250. In the case where there is no instance in which only one battery cell is gripped until the second transfer module 240a transfers battery cells to the loading conveyor 250 in a number equal to the total number of battery cells that the transfer device 150 can transfer at a time, the second transfer module 240a grips a dummy battery cell seated on the dummy conveyor 258 and the battery cell seated on the temporary loading unit 245, and transfers the dummy battery cell and the battery cell to the loading conveyor 250.

The loading conveyor 250 is disposed at a location offset from the axis along which the devices 110 to 150 are aligned, and particularly spaced apart from the first device 120 by a predefined distance, such that the transfer device 150 may transfer to the first device 120 the maximum number of battery cells it is capable of transferring at a time. The loading conveyor 250 may include a rail 510 configured to rotate, and teeth 520 that are provided on the rail 510 and configured to receive battery cells transferred thereto. A predefined number of battery cells are seated on the tooth 520 that is positioned closest to the second transfer module 240a by the second transfer module 240a. After the seating, the loading conveyor 250 rotates the rail 510 to move the seated battery cells away from the second transfer module 240a. Accordingly, an empty tooth 520 is positioned again at the location closest to the second transfer module 240a, and battery cells transferred by the second transfer module 240a are seated again on the empty tooth 520. The loading conveyor 250 continuously seats battery cells through the above-described process, and when the number of seated battery cells reaches the number that the transfer device 150 can transfer at a time, the transfer device 150 transfers the corresponding battery cells to the first device 120.

The unloading conveyor 254 has the same structure as the loading conveyor 250 and receives battery cells that have been determined to be defective or have passed all testing by the third devices 140a to 140n. The battery cells that have been determined to be defective or have passed all testing by the third devices 140a to 140n are seated on the unloading conveyor 254 by the transfer device 150. When a battery cell located close to the second transfer module 240b is transferred by the second transfer module 240b, the unloading conveyor 254 rotates a rail so that a (another) battery cell can be positioned close to the second transfer module 240b.

The dummy conveyor 258 stores dummy battery cells seated thereon and supplies the dummy battery cells to the second transfer module 240a. As described above, when the number of battery cells transferred by the second transfer module 240a is not sufficient to reach the total number of battery cells that the transfer device 150 can transfer at a time, the dummy conveyor 258 allows the second transfer module 240a to additionally grip the dummy battery cells to satisfy the required number.

The first transfer module 220b, the shuttle unit 230b, and the second transfer module 240b respectively have the same structures as the first transfer module 220a, the shuttle unit 230a, and the second transfer module 240a.

However, the second transfer module 240b reciprocates between the unloading conveyor 254 and the shuttle unit 230b, and transfers the battery cells seated on the unloading conveyor 254 to the shuttle unit 230b.

The shuttle unit 230b reciprocates between the first transfer module 220b and the second transfer module 240b, and transfers the battery cells seated thereon by the second transfer module 240b to a lower end of the first transfer module 220b, thereby allowing the first transfer module 220b to transfer the battery cells.

The first transfer module 220b reciprocates between the shuttle unit 230b and the tray seating unit 210d, and transfers the battery cells, which are transferred from the shuttle unit 230b, to a tray seated in the tray seating unit 210d.

The holding device 110 has the above-described structure, thereby enabling the battery cells in the incoming tray to be smoothly transferred at a time by the transfer device 150 (in a number corresponding to the number of battery cells that the transfer device 150 can transfer), and enabling the battery cells which have been determined to be defective or have passed testing to be smoothly transferred to the tray such that the battery cells can be transferred out.

FIG. 6 is a perspective view illustrating a configuration of the pressurized short-circuit test device according to an embodiment of the present disclosure.

Referring to FIG. 6, the first device 120 according to an embodiment of the present disclosure includes a pressing element 610, a jig press plate 620, a pressing plate 625, jig plates 630, a battery cell grip assisting module 640, a first rail 650, a second rail 655, a frame 660, a first fixed plate 664, a second fixed plate 668, a pressure sensor 670, a support plate 680, an elastic element 685, and a guide shaft 690.

The pressing element 610 receives power from an external source and applies pressure to the jig press plate 620. For example, the pressing element 610 may be implemented in a configuration such as a jack screw, which receives rotational force and converts the rotational force into linear reciprocating motion. Alternatively, the pressing element 610 may be implemented in a configuration that receives power and performs linear reciprocating motion.

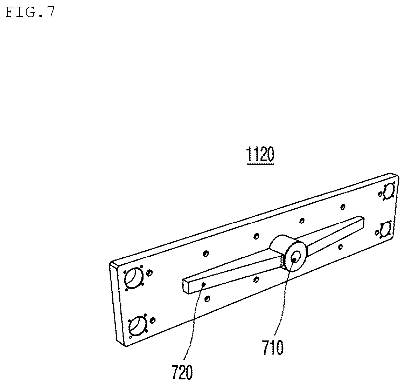

The jig press plate 620 receives pressure from the pressing element 610 and applies pressure to each jig plate 630 and the battery cells disposed between the jig plates 630. The jig press plate 620 has a structure shown in FIG. 7.

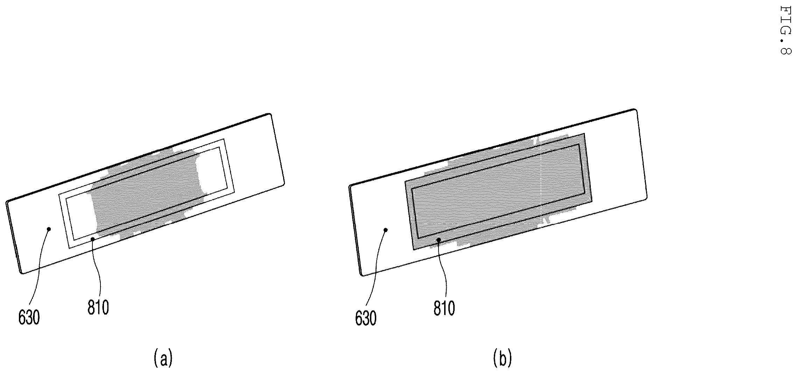

FIG. 7 is a perspective view of the jig press plate according to an embodiment of the present disclosure. FIG. 8 is a view illustrating a region of the jig plate to which pressure is applied by the jig press plate according to an embodiment of the present disclosure.

Referring to FIG. 7, the jig press plate 620 according to an embodiment of the present disclosure includes a pressing portion 710 and wing portions 720.

The jig press plate 620 is implemented in a rectangular shape having a length in a longitudinal direction relatively greater than a length in a height direction.

The pressing portion 710 is physically connected to the pressing element 610, and receives pressure from the pressing element 610 to apply pressure to another component.

The wing portions 720 are regions extending in respective longitudinal directions from the pressing portion 710 and serve to disperse the pressure transmitted by the pressing element 610. As the wing portions 720 are provided and disperse the pressure, the jig press plate 620 is able to apply uniform pressure to the battery cells disposed between the jig plates. The aforementioned description is supported by FIG. 8.

Referring to FIG. 8(a), in the case where only the pressing portion is provided, it can be seen that the pressure is not evenly applied to an area 810 corresponding to the battery cell in the jig plate 630 (which is schematically illustrated in FIG. 8), but is concentrated only on a central portion thereof.

On the other hand, referring to FIG. 8(b), it can be seen that, due to the presence of the wing portions 720, the pressure is evenly applied to the area 810 corresponding to the battery cell.

Referring again to FIG. 7, the wing portions 720 extend only in the longitudinal direction. In the case where the wing portions 720 extend not only in the longitudinal direction but also in a height direction, there arises a problem in that pressure is less dispersed in the longitudinal direction, thereby failing to achieve uniform pressure distribution. Therefore, the wing portions 720 extend only in the longitudinal direction from the pressing portion 710.

In addition, the wing portions 720 are implemented in a structure that includes at least an inclined surface (triangle) as extending from the pressing portion 710. The wing portions 720 have a length predefined by a length of a surface in contact with a jig plate, and have at least the form of an inclined surface. Provided that the surface in contact with the jig plate has the predefined length, the wing portions 720 may be implemented in a fan shape or a rectangular shape instead of the inclined surface.

Referring again to FIG. 6, the pressing plate 625 is disposed on a side opposite to the jig press plate 620 and receives pressure transmitted through the jig press plate 620 and the jig plates 630.

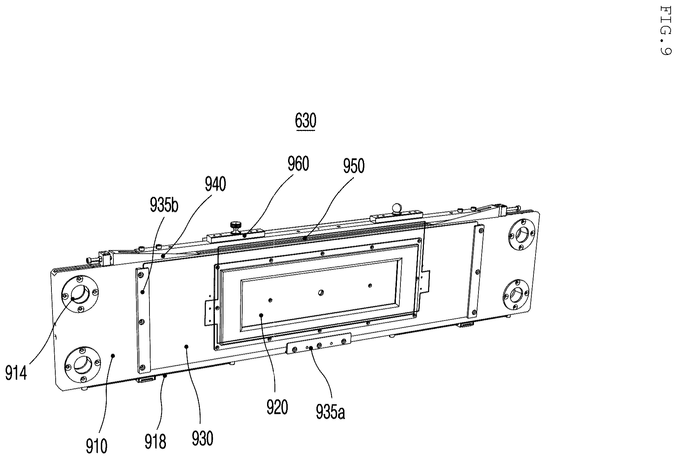

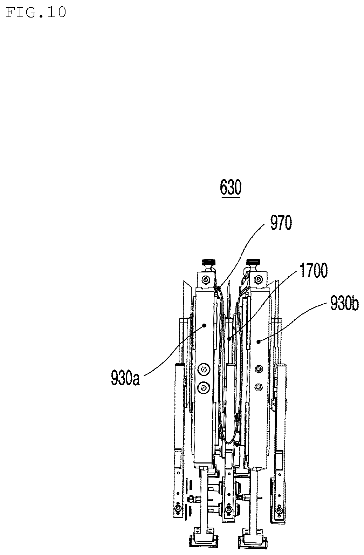

The jig plates 630 are provided in a quantity greater by one than the number of battery cells to be tested at a time, and are configured to apply pressure to the battery cells disposed between the jig plates 630. The jig plates 630 and the battery cells disposed between the jig plates 630 are illustrated in FIGS. 9 and 10.

FIG. 9 is a perspective view of the jig plate according to an embodiment of the present disclosure. FIG. 10 is a side view of the jig plate according to an embodiment of the present disclosure.

Referring to FIGS. 9 and 10, the jig plate 630 according to an embodiment of the present disclosure includes a jig frame 910, a guide hole 914, a rail 918, a pad 920, a pad fastening plate 930, a support sheet height adjuster 940, a support sheet fastener 950, and a support-sheet support portion 960.

The jig frame 910 provides space in the jig plate 630 in which other components are disposed or secured. The jig frame 910 has a predefined area and width (a length in a direction in which the pressing element applies pressure as shown in FIG. 6) to allow each component to be disposed and fixed thereon.

The guide hole 914 is formed as a through-hole in the jig frame 910, allowing the guide shaft 690 to pass through the jig plate 630. As the guide shaft 690 passes through the guide hole 914, the jig plate 630 moves along an axis (a third axis) formed by a cylinder along the guide shaft 690.

The rail 918 is formed along the jig frame 910 at a lowermost end of the jig frame 910 and allows the battery cell grip assisting module 640, which is coupled to the rail 918, to move along the rail 918. Because the jig plate 630 including the jig frame 910 is required to press a battery cell seated thereon, the jig plate 630 is oriented in a direction of a first axis and moves along the third axis to press the battery cell. The rail 918 is formed at the above-described position in the direction of the first axis. Accordingly, the battery cell grip assisting module 640, which is coupled to the rail 918, may move along the rail 918 in the direction of the first axis either toward or away from the battery cell.

The pad 920 is disposed on a surface of the jig frame 910 that faces an adjacent jig plate 630, and prevents damage to the battery cell during a process of pressing the battery cell. The pad 920 is formed of a material having elasticity or a hardness equal to or less than a predefined reference value (i.e., not hard), so as to absorb impact upon contact with the battery cell and prevent damage resulting from the contact.

The pad fastening plate 930 fastens the pad 920 to the above-described surface of the jig frame 910. The pad fastening plate 930 is fastened to the jig frame 910 by a fastener 935. The pad is fastened to a portion (for example, a central portion) of the pad fastening plate 930. For example, the pad fastening plate 930 enables the pad to be fastened thereto by various methods, such as by including a structure that allows the pad to be disposed and coupled to a portion thereof, or being recessed in a shape corresponding to the pad.

The support sheet height adjuster 940, the support sheet fastener 950, and the support-sheet support portion 960 are positioned on an upper surface of the jig frame 910 to allow a support sheet 970 to be disposed between the jig plates 630 and to adjust a height of the support sheet.

As shown in FIG. 10, the support sheet 970 is disposed to allow a battery cell to be placed between the jig plates 630. Because the battery cell cannot be placed in midair, the support sheet 970 is fastened to each jig plate 630 by the support sheet fastener 950 and the support sheet support portion 960. In addition, liquid leakage may occur from the battery cell during pressing of the battery cell. In such a case, if the support sheet 970 is not provided, the leaked liquid may fall onto equipment of the battery cell test device 600 and cause various adverse effects. Because the support sheet 970 is fastened to each jig plate 630, the battery cell can be placed on the support sheet 970 between the corresponding jig plates 630, thereby preventing the aforementioned problem.

In this case, the support sheet fastener 950 and the support sheet support portion 960 fasten the support sheet 970 in place, and the support sheet height adjuster 940 adjusts the height of the support sheet 970 by adjusting a height of the support sheet fastener 950 that fastens the support sheet 970 in place. Because the size of the battery cell may vary depending on type, height adjustment of the battery cell is necessary for the battery cell grip assisting module 640 to easily secure the battery cell in place. To this end, the support sheet height adjuster 940 adjusts the height of the support sheet 970 by adjusting the height of the support sheet fastener 950.

Referring again to FIG. 6, the battery cell grip assisting module 640 moves along the third axis and the first axis, secures the battery cells disposed between the jig plates 630 in place, and presses the battery cells. Two battery cell grip assisting modules 640 are provided and arranged to face each other, and secure the battery cells, particularly electrodes in the battery cells, in place from opposite sides.

The first rail 650 is disposed on the frame 660 along the third axis, and allows the battery cell grip assisting modules to move toward or away from each other.

The second rail 655 is disposed under the frame 660 along the first axis, and allows each frame 660 to move toward or away from one another (along the first axis). The second rail 655 is disposed under the frame 660 along the first axis, and the frame 660 is connected to the second rail 655 through a guide (not shown) provided on a lower end of the frame 660. Accordingly, the frame 660 moves along the second rail 655 in the direction of the first axis so that the frames 660 approach or separate from each other.

The frames 660 support the respective battery cell grip assisting modules 640 and the first rail 650, and provide space in which the cell grip assisting modules 640 and the first rail 650 are disposed. The frames 660 may move toward or away from each other along the second rail 655, and the battery cell grip assisting modules 640 may also move toward or away from each other along the rail 918.

The first fixed plate 664 supports the pressing element 610 so that the pressing element 610 is coupled to the jig press plate 620 without separation and can reliably press the jig press plate 620.

The second fixed plate 668 secures the pressure sensor 670 in place and maintains a gap between the second fixed plate 668 and the support plate 680 in which the pressure sensor 670 can be disposed.

The pressure sensor 670 senses pressure applied to the support plate 680. The pressure sensor 670 senses pressure applied to the support plate 680 between the second fixed plate 668 and the support plate 680, and senses the magnitude of pressure applied to each battery cell. The jig press plate 620 is pressed by the pressing element 610 and presses each jig plate 630. The jig plates 630 and the battery cells disposed therebetween transmit pressure to adjacent jig plates 630 due to the pressing, and are all compressed toward the support plate 680. Ultimately, pressure for reducing a gap between the jig plates 630 is transmitted to the support plate 680, and the pressure sensor 670 senses the pressure.

The elastic element 685 transmits the pressure transmitted to the pressing plate 625 to the support plate 680, and prevents the pressing plate 625 under pressure from colliding with the support plate 680.

The guide shaft 690 is disposed to pass through the guide holes 914 of the respective jig plates 630, and allows the jig plates 630 to move along an axis on which the guide shaft 690 is disposed. Opposite ends of the guide shaft 690 are fixed to the respective fixed plates 664 and 668, and the guide shaft 690 passing through the guide holes 914 of the respective jig plates 630 is disposed along the third axis. Accordingly, when receiving pressure from the jig press plate 620, the jig plates 630 can move along the guide shaft 690.

FIG. 11 is a view illustrating a configuration of the preheating and prepressurizing device according to an embodiment of the present disclosure.

Referring to FIG. 11, the second device 130 according to an embodiment of the present disclosure includes a pressing element 1110, a jig press plate 1120, a pressing plate 1125, a guide portion 1130, jig plates 1140, a first rail 1150, a second rail 1155, a frame 1160, a fixed plate 1164, a ball screw 1168, a pressure sensor 1170, a support plate 1180, and an elastic element 1185. Here, the operations of the pressing plate 1125, the pressure sensor 1170, and the elastic element 1185 are the same as those of the pressing plate 625, the pressure sensor 670, and the elastic element 685, and thus repeated descriptions are omitted.

The pressing element 1110 receives power from an external source and transmits rotational force to the ball screw 1168. The pressing element 1110 transmits rotational force to the ball screw 1168 so that the ball screw 1168 rotates in a specific direction, thereby allowing the jig press plate 1120 to apply pressure to each jig plate 1140 or stop applying the pressure.

The jig press plate 1120 applies pressure to each jig plate 1140 and battery cells disposed between the jig plates 1140 or stop applying the pressure, depending on the rotation of the ball screw 1168. The jig press plate 1120 moves toward or away from the pressing plate 1125 depending on the rotation of the ball screw 1168. Accordingly, the jig press plate 1120 moves toward the pressing plate 1125 to apply pressure to the jig plates 1140 and the battery cells disposed between the jig plates, and moves away from the pressing plate 1125 to stop applying the pressure.

The guide 1130 is disposed to pass through guide coupling portions 1213 (to be described below with reference to FIG. 12) formed in the jig plates 1140, and allows the jig plates 1140 to move along the guide 1130. Opposite ends of the guide 1130 are respectively fixed to the jig press plate 1120 and the pressing plate 1125. Two guides 1130 are spaced apart by a distance corresponding to a spacing between the guide coupling portions 1213 formed on opposite sides of each jig plate 1140, and respectively pass through the guide coupling portions 1213 formed on the opposite sides of the jig plates 1140. Accordingly, the guides 1130 prevent the jig plates 1140 from being displaced and allow adjacent jig plates 1140 to move toward or away from each other along the guides 1130.

The jig plates 1140 are provided in a quantity greater by one than the number of battery cells to be tested at a time, and are configured to apply pressure to the battery cells disposed between the jig plates 1140. The jig plate 1140 is illustrated in FIG. 12.

FIG. 12 is a perspective view of the jig plate in the preheating and prepressurizing device according to an embodiment of the present disclosure.

Referring to FIGS. 12A and 12B, the jig plate 1140 according to an embodiment of the present disclosure includes a jig frame 1210, guide coupling portions 1213, a first rail coupling portion 1216, a second rail coupling portion 1219, a heating pad 1220, and support sheet fasteners 1240 and 1245.

The jig frame 1210 provides space in the jig plate 1140 in which other components are disposed or secured. The jig frame 1210 has a predefined area and width to allow each component to be disposed and secured thereon.

The guide coupling portions 1213 have structures respectively protruding from opposite ends of the jig frame 1210 at a height at which the guides 1130 are positioned, and each include a through-hole to allow the corresponding guide 1130 to pass through the jig plate 1140. The guide coupling portions 1213 are physically connected to the opposite ends of the jig frame 1210 and have structures protruding from the jig frame 1210. Each guide coupling portion 1213 includes the through-hole therein. Accordingly, the guides 1130 can pass through the respective guide coupling portions 1213, and the jig plate 1140 can move along the guide 1130 via the guide coupling member 1213 without being displaced from the first device 120.

The first rail coupling portion 1216 has a structure protruding from each guide coupling portion 1213 and couples the guide coupling portion 1213 to the first rail 1150. The first rail coupling portion 1216 is implemented to have a shape complementary to a cross-section of the first rail 1150 (e.g., a shape that presses the rail from above and below), and is thus physically coupled to the first rail 1150. As a result, the guide coupling portion 1213 and the jig frame 1210 are ultimately coupled to the first rail 1150 by the first rail coupling portion 1216.

The second rail coupling portion 1219 has a structure protruding from each of the opposite ends of the jig frame 1210 at a height at which the second rail 1155 is positioned, and couples the jig frame 1210 to the second rail 1155. The second rail coupling portion 1219 has the same shape as the first rail coupling portion 1216 and is coupled to the second rail 1155. Accordingly, the second rail coupling portion 1219 couples the jig frame 1210 to the second rail 1155.

The heating pad 1220 generates heat when pressure is applied thereto. The heating pad 1220 is disposed on each surface of the jig frame 1210 facing an adjacent jig plate 1140, and generates heat. When the adjacent jig plates 1140 are pressed by movement of the jig press plate 1120, the heating pad 1220 generates heat in response to the applied pressure and heats the battery cell disposed between the jig plates 1140.

A support sheet 1230 is disposed to enable the battery cell to be placed between adjacent jig plates 1140. The support sheet fasteners 1240 and 1245 fasten the support sheet 1230 between the jig plates 1140. The support sheet fastener 1245 is coupled to an upper end of the jig frame 1210, and the support sheet fasteners 1240 and 1245 are disposed in a configuration that presses the support sheet 1230 interposed therebetween. Accordingly, the support sheet 1230 is secured in place by the support sheet fasteners 1240 and 1245.

Referring again to FIG. 11, the jig plate 1140 located closest to the jig press plate 1120 is physically connected to the jig press plate 1120. The jig press plate 1120 and the jig plate 1140 are physically connected as described above, and the jig plate 1140 moves together with the jig press plate 1120 in response to movement of the jig press plate 1120.

The first rail 1150 at an upper portion and the second rail 1155 at a lower portion have opposite ends respectively fixed to the jig press plate 1120 and the pressing plate 1125, and physically connect adjacent jig plates 1140. As described above, each jig plate 1140 includes the rail coupling portions 1216 and 1219, and all of the jig plates 1140 are physically connected to one another by the rails 1150 and 1155. Even in the absence of the respective rails 1150 and 1155, the jig press plate 1120 may apply pressure to the jig plates 1140 without difficulty. However, when the jig press plate 1120 moves away from the pressing plate 1125 (to stop applying the pressure) in the absence of the rails 1150 and 1155, only the jig plate 1140 positioned closest to the jig press plate 1120 may move along with the jig press plate 1120, while the remaining jig plates 1140 fail to move. Accordingly, applying the pressure to the battery cells may not be stopped. To prevent the foregoing, the respective rail coupling portions 1216 and 1219 of the jig plates 1140 are coupled to the first rail 1150 and the second rail 1155, so that all of the jig plates 1140 are connected to each other by the rails. In the case where the jig press plate 1120 moves (in a direction away from the pressing plate), the jig plate 1140 positioned closest thereto moves accordingly, and the adjacent jig plates 1140 that are connected through the rails successively move in the same direction. Because the jig plates 1140 are coupled to the rails 1150 and 1155, the jig plates 1140 can reciprocate along the guides 1130 by the jig press plate 1120.

The frame 1160 secures the pressing element 1110, the guides 1130, and the ball screw 1168 in place.

The fixed plate 1164 includes a plurality of gears therein and receives rotational force from the pressing element 1110 to transmit the rotational force to the ball screw 1168.

The ball screw 1168 rotates according to the rotational force transmitted thereto via the fixed plate 1164, and moves the jig press plate 1120 forward (in a direction approaching the pressing plate) or backward (in a direction away from the pressing plate). One end of the ball screw 1168 is supported by the fixed plate 1164, and a remaining end thereof is supported by a housing, and the ball screw 1168 rotates in position by the rotational force supplied from the fixed plate 1164. The ball screw 1168 is coupled to the jig press plate 1120, which is threaded over the ball screw 1168, and moves the jig press plate 1120 forward or backward as the ball screw 1168 rotates.

The second device 130, including the above-described configuration, may heat and press the battery cells at a preceding stage to the third devices 140a to 140n.

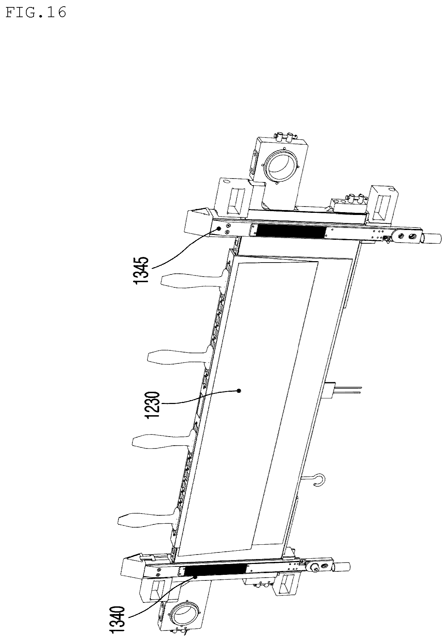

FIG. 13 is a view illustrating a configuration of the high-temperature pressurized charging/discharging device according to an embodiment of the present disclosure. FIG. 16 is a view illustrating a structural relationship among the jig plate, the charge/discharge gripper, and a battery cell in the high-temperature pressurized charging/discharging device according to an embodiment of the present disclosure.

Referring to FIGS. 13 and 16, each of the third devices 140a to 140n according to an embodiment of the present disclosure include a pressing element 1310, a jig press plate 1320, a pressing plate 1325, a guide 1330, a charge/discharge gripper guide 1335, jig plates 1340, charge/discharge grippers 1345, a first rail 1350, a second rail 1355, a frame 1360, a fixed plate 1364, a ball screw 1368, a pressure sensor 1370, a support plate 1380, and an elastic element 1385. Except for the charge/discharge gripper guide 1335 and the charge/discharge grippers 1345, the other components in the third devices 140a to 140n perform the same operations as those of the second device 130, and therefore, repeated descriptions are omitted.

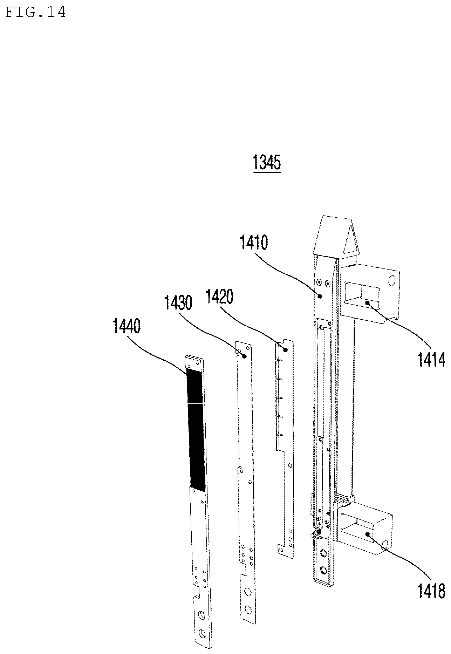

The charge/discharge gripper guide 1335 is disposed to pass through guide coupling portions 1414 and 1418 (to be described below with reference to FIG. 14) in each charge/discharge gripper 1345, and allows the charge/discharge grippers 1345 to move along the charge/discharge gripper guide 1335. Opposite ends of the charge/discharge gripper guide 1335 are respectively fixed to the frame 1360 and the fixed plate 1364. Two charge/discharge gripper guides 1335 are arranged above and below with a spacing corresponding to a distance between the guide coupling portions 1414 and 1418, and respectively pass through the guide coupling portions 1414 and 1418. Two pairs of charge/discharge gripper guides 1335, each pair including two charge/discharge gripper guides 1335 arranged above and below, are spaced apart at a predefined distance on the axis (x-axis) along which the devices 110 to 150 are aligned. Accordingly, the charge/discharge gripper guides 1335 prevent the charge/discharge grippers 1345 from being displaced, and allow the charge/discharge grippers 1345 to move along the charge/discharge gripper guides 1335 in conjunction with the movement of the jig plates 1340.

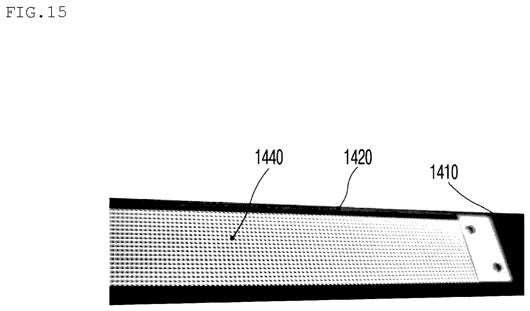

The charge/discharge grippers 1345 are coupled to both leads of a battery cell disposed between the jig plates 1140, supply current to the battery cell, and measure a voltage of the battery cell. The structure of the charge/discharge gripper 1345 is illustrated in FIGS. 14 and 15.

FIG. 14 is a view illustrating a configuration of the charge/discharge gripper according to an embodiment of the present disclosure. FIG. 15 is a view illustrating an implementation example of the charge/discharge gripper according to an embodiment of the present disclosure.

Referring to FIGS. 14 and 15, the charge/discharge gripper 1345 according to an embodiment of the present disclosure includes a body 1410, guide coupling portions 1414 and 1418, a voltage measurement terminal 1420, an insulator 1430, and a current supply terminal 1440.

The body 1410 supports the components in the charge/discharge gripper 1345.

The guide coupling portions 1414 and 1418 are structures respectively protruding from different heights on one side surface of the body 1410 and each include a through-hole to allow the charge/discharge gripper guides 1335 to pass through the charge/discharge gripper 1345. The guide coupling portions 1414 and 1418 each have a structure that is physically connected to the one side surface of the body 1410 and protrudes from the body 1410. Each of the guide coupling portions 1414 and 1418 includes the through-hole therein. Accordingly, the charge/discharge gripper guides 1335 can pass through the guide coupling portions 1414 and 1418, and the jig plate 1140 can move along the charge/discharge gripper guides 1335 in the third devices 140a to 140n without being displaced.

The voltage measurement terminal 1420 is electrically connected to the corresponding lead of the battery cell to measure the voltage of the battery cell. The voltage measurement terminal 1420 is physically coupled to a front or rear surface (a surface facing the jig plate) of the body 1410. When the jig plates 1340 apply pressure to the battery cell disposed therebetween, the voltage measurement terminal 1420 is electrically connected to the corresponding lead of the battery cell.

The insulator 1430 electrically isolates the voltage measurement terminal 1420 from the current supply terminal 1440. The insulator 1430 is physically coupled to an upper surface of the voltage measurement terminal 1420 in a direction in which the voltage measurement terminal 1420 is coupled to the body 1410. Accordingly, when the jig plates 1340 apply pressure to the battery cell disposed therebetween, the insulator 1430 prevents the voltage measurement terminal 1420 and the current supply terminal 1440 from being electrically connected due to the pressure.

The current supply terminal 1440 is electrically connected to the corresponding lead of the battery cell to supply current to the battery cell. The current supply terminal 1440 is physically coupled to an upper surface of the insulator 1430 in the direction in which the voltage measurement terminal 1420 is coupled to the body 1410. The current supply terminal 1440 is electrically connected to the lead of the battery cell and supplies current to the battery cell to allow the battery cell to be charged or discharged.

Rather than being formed to have the same width, the voltage measurement terminal 1420 and the current supply terminal 1440 are configured such that one has a greater width than the other within a range smaller than that of the body 1410. Accordingly, when the jig plates 1340 apply pressure to the battery cell disposed therebetween and the components 1420 and 1440 are electrically connected to the corresponding lead of the battery cell, the components 1420 and 1440 can be electrically connected to the lead at different positions.

The charge/discharge gripper 1345 is coupled to each of opposite ends of the lead of the battery cell. The voltage measurement terminal 1420 and the current supply terminal 1440 are electrically connected to the respective opposite ends of the lead of the battery cell, and each of the voltage measurement terminal 1420 and the current supply terminal 1440 forms a closed circuit with the battery cell to perform the above-described operations (current supply and voltage measurement). As the charge/discharge gripper 1345 is coupled to each of the opposite ends of the lead of the battery cell, the pair of charge/discharge gripper guides 1335 arranged above and below are also positioned at the respective opposite ends of the lead of the battery cell to prevent both charge/discharge grippers 1345 from being displaced.

The above description is merely an illustrative description of the technical spirit of the present disclosure, and those skilled in the art may change and modify the present disclosure in various ways without departing from the essential characteristic of the present disclosure. Accordingly, the embodiments described in the present disclosure should not be construed as limiting the technical spirit of the present disclosure, but should be construed as describing the technical spirit of the present disclosure. The technical spirit of the present disclosure is not restricted by the embodiments. The range of protection of the present disclosure should be construed based on the following claims, and all of technical spirits within an equivalent range to the claims should be construed as being included in the scope of rights of the present disclosure.

## Claims

1. A battery cell holding device configured to receive a tray loaded with battery cells to be tested, unload the battery cells from the tray and hold the battery cells, load tested battery cells into the tray, and transfer out the tray loaded with the tested battery cells, the battery cell holding device comprising:
a tray seating unit configured to receive an incoming tray and an empty tray from which the battery cells are transferred;
a loading conveyor configured to load a predefined number of battery cells transferred thereto;
a shuttle unit configured to transfer the battery cells introduced thereinto and secured in place from one position to another position;
a first transfer module configured to reciprocate between the tray seating unit and the shuttle unit and transfer the battery cells in the tray seated in the tray seating unit to the shuttle unit; and
a second transfer module configured to reciprocate between the shuttle unit and the loading conveyor and transfer, to the loading conveyor, the battery cells transferred by the shuttle unit.

2. The battery cell holding device of claim 1, wherein the shuttle unit holds the battery cells transferred from the first transfer module and transfers the battery cells to the second transfer module.

3. The battery cell holding device of claim 2, wherein the shuttle unit comprises a guide formed along an axis, a body configured to move along the guide, a motor configured to provide driving force to allow the body to move along the guide, and a battery cell holder protruding from the body in a vertical upward direction and holding the battery cells.

4. The battery cell holding device of claim 3, wherein the battery cell holder comprises two battery cell holders facing each other as a set, the two battery cell holders being fixed to be spaced apart by a distance greater than a width of each of the battery cells by a predefined tolerance range.

5. The battery cell holding device of claim 4, wherein each of the battery cells is introduced and held between the set of battery cell holders.

6. The battery cell holding device of claim 5, wherein two sets of battery cell holders, each set including the two battery cell holders, are arranged on an axis identical to an axis of the guide and configured to hold a single battery cell.

7. The battery cell holding device of claim 6, wherein the battery cell holders receive and hold one or more battery cells.

8. The battery cell holding device of claim 1, further comprising:
an unloading conveyor configured to receive a battery cell transferred thereto, the battery cell having been determined to be defective or having passed testing;
a second shuttle unit configured to transfer the battery cell introduced thereinto and secured in place from one position to another position;
a third transfer module configured to reciprocate between the second shuttle unit and the tray seating unit and transfer the battery cells transferred from the second shuttle unit to a tray seated in the tray seating unit; and
a fourth transfer module configured to reciprocate between the unloading conveyor and the second shuttle unit and transfer the battery cell seated on the unloading conveyor to the second shuttle unit.

9. The battery cell holding device of claim 8, further comprising a dummy conveyor configured to store a dummy battery cell seated thereon.

10. A battery cell performance test system comprising:
a battery cell holding device according to any one of claims 1 to 9;
a test device configured to test electrical characteristics of a plurality of battery cells seated therein;
a battery cell transfer device configured to reciprocate between the battery cell holding device and the test device, grip the plurality of battery cells, and transfer the plurality of battery cells from any one device to another device; and
a controller configured to control respective operations of components in the battery cell performance test system.
